# EUROPÄISCHE PATENTANMELDUNG

(11) **EP 2 040 295 A2**
(43) Veröffentlichungstag der Anmeldung: **25.03.2009**
(21) Anmeldenummer: 08014181.5
(22) Anmeldetag: 08.08.2008
(51) Int. Cl.: H01L 23/498, H01L 23/13

(54) **Anordnung mit einer Verbindungseinrichtung und mindestens einem Halbleiterbauelement**

(30) Priorität: 19.09.2007 DE 102007044620
(71) Anmelder: SEMIKRON Elektronik GmbH & Co. KG, 90431 Nürnberg (DE)
(72) Erfinder: Augustin, Karlheinz, 90768 Fürth (DE); Göbl, Christian, 90441 Nürnberg (DE)

(57) **Zusammenfassung**

Die Erfindung stellte eine Anordnung mit einer Verbindungseinrichtung zur elektrisch leitenden Verbindung mit mindestens einem Halbleiterbauelement und mit einem Füllstoff vor. Hierbei ist die Verbindungseinrichtung als Folienbund aus mindestens einer isolierenden und zwei elektrischen Folien ausgebildet, welche in einem Schichtaufbau mit jeweils einer elektrisch leitenden, einer isolierenden und wieder einer elektrisch leitenden Folie abwechseln angeordnet sind und wobei die elektrisch leitenden Folien in sich strukturiert sind und somit Leiterbahnen ausbilden. Mindestens einem Halbleiterbauelement ist mindestens eine Aussparung in der jeweils leitenden Folie zugeordnet, wobei sich zwischen der Verbindungseinrichtung und dem mindestens einen Halbleiterbauelement der Füllstoff befindet.

## Beschreibung

Die Erfindung beschreibt eine Anordnung, vorzugsweise ein kompaktes Leistungshalbleitermodul, mit einer als Folienverbund ausgestalteten Verbindungseinrichtung zur elektrisch leitenden Verbindung mit mindestens einem Leistungshalbleiterbauelement und mit Treiberbausteinen, wobei zwischen dem Leistungshalbleiterbauelement und einer Leiterbahn der Verbindungseinrichtung ein Füllstoff vorgesehen ist.

Zur Kontaktierung von ungehausten Halbleiterbauelementen ist die so genannte "Wende-Montage" (engl. "Flip-Chip-Montage") bekannt, wobei das Halbleiterbauelement direkt und ohne weitere Anschlüsse mit einer elektrisch leitenden Kontaktfläche zu den Leiterbahnen des Schaltungsträgers hin verbunden ist. Die Kontaktierung wird typischerweise mittels Kontaktnoppen erreicht. Das verbleibende Volumen zwischen Leistungshalbleiterbauelement und Leiterbahn wird zum Zwecke der elektrischen Isolation mit einem niederviskosen Füllstoff verfüllt und gebräuchlich als "Prozess des kapillaren Unterfüllens" bezeichnet.

Weiterhin werden in derart hergestellten Leistungshalbleitermodulen Treiberbausteine und weitere elektronische Bauelemente mit der Verbindungseinrichtung beispielhaft klebetechnisch befestigt und mittels Bondtechnik mit Dünndrähten elektrisch leitend verbunden.

Den Stand der Technik bilden beispielhaft die Patentanmeldungen DE 103 55 925 A1, DE 10 2005 053 398 A1 und US 6,624,216.

Die DE 103 55 925 A1 offenbart ein Leistungshalbleitermodul mit einer Verbindungseinrichtung, welche als Folienverbund ausgestaltet ist. Dieser Folienverbund besteht aus mindestens einer ersten und einer zweiten elektrisch leitenden Folie mit einer isolierenden Folie als Zwischenlage. Mindestens eine leitende Folie ist in sich strukturiert und bildet somit voneinander elektrisch isolierte Leiterbahnen aus, auf welchen wiederum Leistungshalbleiterbauelemente schaltgerecht angeordnet sind. Weiterhin weist die leitende Folie Kontaktnoppen auf, durch welche die Leistungshalbleiterbauelemente mit der leitenden Folie mittels Ultraschallschweißens dauerhaft sicher elektrisch verbunden sind.

Die DE 10 2005 053 398 A1 offenbart ein Leistungshalbleitermodul im Sinne der DE 103 55 925 A1, wobei die zweite leitende Folie ebenfalls in sich strukturiert ist und somit Leiterbahnen ausbildet und auf welcher Treiberbausteine vorzugsweise klebetechnisch befestigt und mittels Dünndrahtbondens elektrisch leitend verbunden sind. Die zwischen den leitenden Folien liegende isolierende Folie ist an einer beidseitig metallfreien Stelle mit einer Aussparung versehen, durch welche ein flexibler Dünndraht die elektrische Kontaktierung zwischen erster und zweiter leitender Folie an entsprechenden Bondstellen ermöglicht.

Die US 6,624,216 beschreibt ein Verfahren, in welchem das verbleibende Volumen zwischen einem Leistungshalbleiterbauelement und einer ersten leitenden Folie aus Gründen der elektrischen Sicherheit mit einem Füllstoff versehen wird. Dieser Füllstoff ist vorzugsweise ein Epoxyd-Kunstharz, welches mit abrasiven Substanzen versetzt wird, um den thermischen Ausdehnungskoeffizienten im Füllstoff zu senken und auf diese Art die Temperaturwechsellast, welche typischerweise in Leistungshalbleiteraufbauten entsteht, zu mindern. Diese Technologie wird gemäß dem Stand der Technik typischerweise als "Underfill" oder "Prozess des kapillaren Unterfüllens" bezeichnet.

Nachteilig ist hierbei, dass der Füllstoff beim Prozess des Unterfüllens üblicherweise nicht gleichmäßig an der leitenden Folie haftet und prinzipiell schlechtere Hafteigenschaften gegenüber der leitenden Folie als gegenüber dem Leistungshalbleiterbauelement besitzt.

Weiters nachteilig ist, dass Leistungshalbleiterbauelemente in jeglicher Verbindungseinrichtung generell stressempfindlich gegenüber mechanischer Krafteinwirkung reagieren. Wenn solche Krafteinwirkungen zu Defekten an den Leistungshalbleiterbauelementen führen, werden in Folge die Leit- oder Isolationsfähigkeit zum Leistungshalbleiterbauelement und die Funktion des Leistungshalbleitermoduls nachhaltig beeinträchtigt. Diese Stressempfindlichkeit kann durch den Prozess des kapillaren Unterfüllens mit dem Füllstoff vermindert werden.

Der Erfindung liegt die Aufgabe zugrunde eine Anordnung mit einer als Folienverbund ausgestalteten Verbindungseinrichtung und mit mindestens einem Halbleiterbauelement vorzustellen, wobei die Wirkungsweise des Füllstoffes zwischen dem Leistungshalbleiterbauelement und den Leiterbahnen verbessert wird, indem die Haftung des Füllstoffes gesteigert wird.

Die Aufgabe wird erfindungsgemäß gelöst durch die Merkmale des Anspruchs 1. Bevorzugte Ausführungsformen sind in den Unteransprüchen beschrieben.

Der erfinderische Gedanke geht aus von den Anforderungen einer Anordnung mit einer Verbindungseinrichtung zur elektrisch leitenden Verbindung mit mindestens einem anzuordnenden und schaltungsgerecht zu verbindendem Halbleiterbauelement und mit einem Füllstoff. In einer derartigen Anordnung sind ungehauste Leistungshalbleiterelemente miteinander und / oder mit Leiterbahnen einer elektrisch leitenden Folie, auf dem sie angeordnet sind, zu verbinden. Weiterhin müssen Treiberbausteine und weitere elektronischen Bauelemente verbunden werden. Ebenso sind die externen Anschlüsse der Lastanschlüsse sowie aller notwendigen Steuer- und Hilfsanschlüsse der Leistungshalbleiterbauelemente zu verbinden.

Die Verbindungseinrichtung ist ausgestaltet als ein Folienverbund aus mindestens einer isolierende Folie und zwei elektrisch leitenden Folien. Dieser Folienverbund weist einen Schichtaufbau beginnend mit einer leitenden und dann abwechselnd jeweils einer isolierenden und einer leitenden Folie auf. Mindestens eine leitende Folie ist in sich strukturiert und bildet somit voneinander isolierte Leiterbahnen aus. Die erste Folie weist Kontakteinrichtungen zu den Leistungsanschlussflächen der Leistungshalbleiterbauelemente auf, welche vorzugsweise als Kontaktnoppen ausgestaltet sind und stoff- oder kraftschlüssig vorzugsweise mittels Ultraschallschweißens verbunden sind. Eine zweite leitende Folie weist Kontaktflächen zu den Logikanschlussflächen der Treiberbausteine auf, welche bevorzugt stoffschlüssig mittels Klebeverbindung und mit weiteren Leiterbahnen elektrisch leitend mittels Dünndrahtbondens verbunden sind.

Erfindungsgemäß wird hierbei mindestens eine, vorzugsweise zylinderförmige Aussparung in die Oberfläche mindestens einer leitenden Folie eingebracht, welche eine Fläche von maximal 25 von 100 der Fläche des zugeordneten Halbleiterbauelements aufweist und welche zumindest teilweise in dem vom Halbleiterbauelement überdeckten Bereich angeordnet ist. Diese Anordnung kann vorteilhaft genutzt werden, da üblicherweise elektronische Bauelemente nach ihrer Fertigung mittels bildgebendem Prüfverfahren auf die Richtigkeit ihrer Anordnung geprüft werden. Hierbei bieten sich vorzugsweise Bilderkennungssysteme oder Durchleuchtung mittels Röntgenverfahren an. Die vorzugsweise Anordnung der Aussparungen in dem zumindest teilweise vom Halbleiterbauelement überdeckten Bereich ist hierbei insofern von Vorteil, dass jener Teil der Aussparung, der nicht von dem zugeordneten Halbleiterbauelement überdeckt ist, im bildgebenden Prüfverfahren zur Kontrolle der ordnungsgemäßen Anordnung der Aussparungen dienen kann.

Die Tiefe der mindestens einen Aussparung beträgt hierbei mindestens 20 von 100, maximal 100 von 100 der Tiefe der elektrisch leitenden Folie. Die Gesamtfläche aller einem Halbleiterbauelement zugeordneten Aussparungen beträgt maximal 50 von 100 der Fläche des Halbleiterbauelements.

Im Bereich der als Leistungsanschlussfläche vorgesehenen elektrisch leitenden Folie wird diese mit dem mindestens einen Leistungshalbleiterbauelement kraft- oder stoffschlüssig verbunden und beispielhaft das verbleibende Volumen mit Isolierstoff verfüllt. Die mindestens eine Aussparung ermöglicht vorteilhaft ein Eindringen des Füllstoffes in die Aussparung, was die Verankerungsfestigkeit des Isolierstoffes an der elektrisch leitenden Folie in ausgehärtetem Zustand wesentlich verbessert.

Im Bereich der zweiten elektrisch leitenden Folie wird diese mit mindestens einem Treiberbaustein stoffschlüssig vorzugsweise klebetechnisch verbunden, wobei die Aussparung auch hier ein Einsickern des beispielhaft verwendeten Klebematerials und damit eine bessere Verankerung ermöglicht.

Der Prozess der Leiterbahnenstrukturierung findet beispielhaft mittels Ätzverfahren statt. Vorteilhaft ist hierbei, dass die Anfertigung der Aussparungen im Zuge des Fertigungsschrittes der Strukturierung der Leiterbahnen auf der elektrisch leitenden Folie erfolgen kann.

Besonders bevorzugte Weiterbildungen dieser Anordnung sind in der jeweiligen Beschreibung der Ausführungsbeispiele genannt. Die erfinderische Lösung wird zudem an Hand der Ausführungsbeispiele der Fig. 1 bis 4 weiter erläutert.

Fig. 1 zeigt im Querschnitt eine erste Ausgestaltung der erfindungsgemäße Anordnung mit einer als Folienverbund ausgestalteten Verbindungseinrichtung und Halbleiterbauelementen und einen vergrößerten Ausschnitt einer erfindungsgemäßen Anordnung.

Fig. 2 zeigt einen Ausschnitt einer ersten Ausgestaltung der erfindungsgemäßen Anordnung der Leistungshalbleiterelemente auf den strukturierten Leiterbahnen der elektrisch leitenden Folie in Draufsicht.

Fig. 3 zeigt einen Ausschnitt einer weiteren Ausgestaltung der erfindungsgemäßen Anordnung der Leistungshalbleiterelemente auf den strukturierten Leiterbahnen des Substrates in Draufsicht.

Fig. 4 einen Ausschnitt einer weiteren Ausgestaltung der erfindungsgemäßen Anordnung der Leistungshalbleiterelemente auf den strukturierten Leiterbahnen des Substrates in Draufsicht.

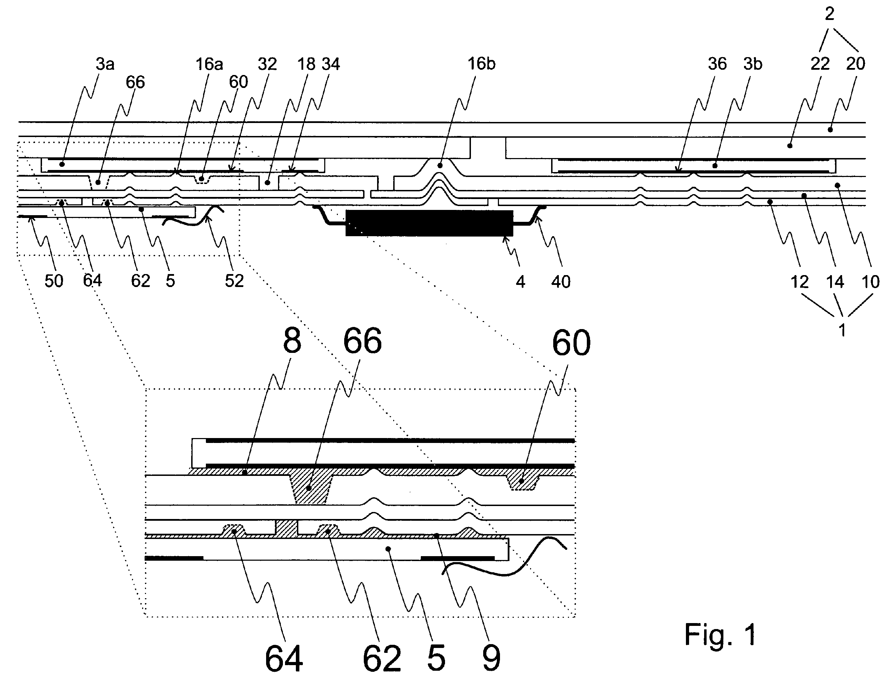

Fig. 1 zeigt eine erfindungsgemäße Anordnung mit einer als Folienverbund (10,12,14) ausgestalteten Verbindungseinrichtung (1) und Bauelemente (3 a/b, 4, 5) im Querschnitt. Der Folienverbund besteht aus mindestens einer isolierende Folie (14) und zwei elektrisch leitenden Folien (10, 12) und weist einen Schichtaufbau beginnend mit einer leitenden (10) und dann abwechselnd jeweils einer isolierenden (14) und einer leitenden (12) Folie auf. Mindestens eine leitende Folie ist in sich strukturiert (18) und bildet somit voneinander isolierte Leiterbahnen (100, 120) aus.

Die auf den Leiterbahnen (100, 120) der ersten elektrisch leitenden Folie (10) angeordneten Leistungshalbleiterbauelemente (3a, 3b) sind hier eine Leistungsdiode (3b) und ein Leistungstransistor (3a), wobei dies keine Beschränkung auf diese Bauelemente bedeutet. Diese Leistungshalbleiterbauelemente (3) weisen auf ihrer der Verbindungseinrichtung (1) zugewandten Seite jeweils mindestens eine Kontaktfläche (32) auf. Zur elektrisch leitenden Verbindung der ersten elektrisch leitenden Folie (10) mit den Kontaktflächen (32) der Leistungshalbleiterbauelemente (3 a/b) weist der Folienverbund (1) beispielhaft erste Kontaktnoppen (16 a,b) auf. Das Volumen zwischen der ersten elektrisch leitenden Folie (10) und dem mindestens einen Leistungshalbleiterbauelement (3 a/b) ist mit einem niederviskosen Füllstoff (8) verfüllt.

Die auf der zweiten elektrisch leitenden Folie (12) angeordneten Halbleiterbauelemente (4, 5) sind beispielhaft Treiberbausteine und dienen der Steuerung des Leistungshalbleiterbauelements. Sie sind hier stoffschlüssig bevorzugt klebetechnisch (9) befestigt und mittels Dünndrahtbondens (52) mit weiteren Leiterbahnen der zweiten elektrisch leitenden Folie (12) verbunden.

Die Aussparungen (60, 62, 64, 66) befinden sich an mindestens einer Stelle auf mindestens einer leitenden Folie (10, 12) in einem zumindest teilweise von einem Halbleiterbauelement (3/4/5) überdeckten Bereich. Beispielhaft sind einige Aussparungen (60, 66) zylinderförmig, andere (62,64) kreuzförmig ausgestaltet (hier im Querschnitt nicht unterscheidbar darstellbar). Weiters betragen einige Aussparungen (60, 64) vorzugsweise 30 von 100 Tiefe der Dicke der elektrisch leitenden Folie, andere (62, 66) 100 von 100 Tiefe der Dicke der elektrisch leitenden Folie. Die Gesamtfläche aller einem Halbleiterbauelement zugeordneten Aussparungen (60 und 66, 62 und 64) beträgt hier beispielhaft 20 von Hundert, jedenfalls maximal 50 von 100 der Fläche des zugeordneten Halbleiterbauelements. Die Fläche jeder einzelnen Aussparung beträgt jedenfalls maximal 25 von 100 der Fläche des zugeordneten Halbleiterbauelements.

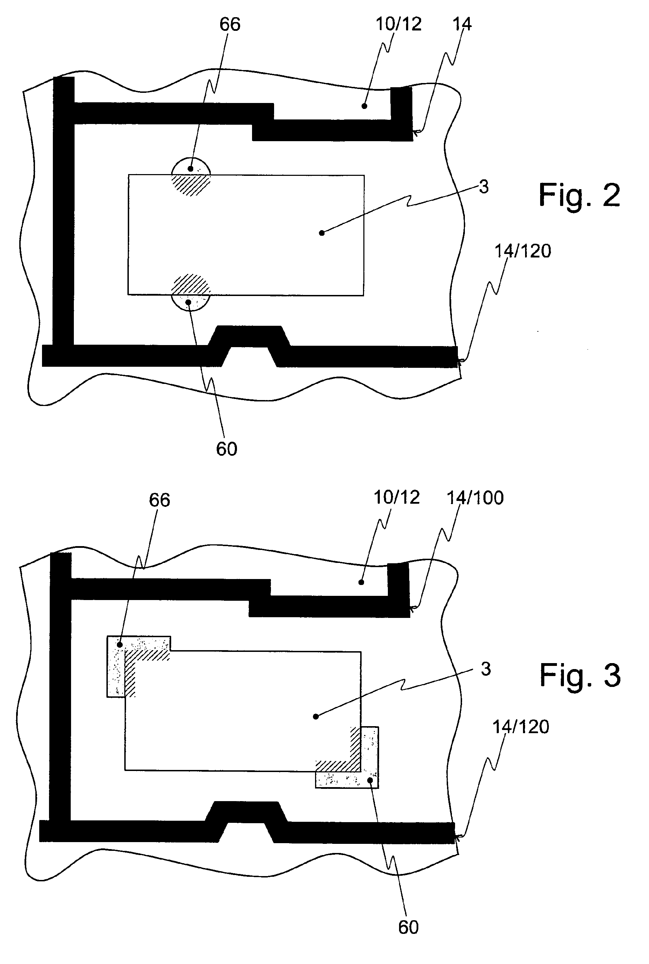

Fig. 2 zeigt einen Ausschnitt einer erfindungsgemäßen Anordnung (1) in beispielhafter Draufsicht auf eine Verbindungseinrichtung (1), wobei ebenfalls der in Fig. 1 beschriebene dreischichtige Aufbau vorausgesetzt wird. Dargestellt ist eine elektrisch leitende Folie (10), welche in sich strukturiert (18) ist und somit hier beispielhaft drei Leiterbahnen ausbildet und eine in den Strukturbahnen (18) sichtbar werdende isolierende Folie (14). Weiterhin dargestellt ist ein Halbleiterbauelement (3) und Aussparungen (60, 66) in einer bevorzugten Anordnung, indem die Aussparungen rund ausgestaltet sind und sich zumindest mit einem Segmentabschnitt unter dem Halbleiterbauelement befinden, während ein zweiter Segmentabschnitt sichtbar hervorragt.

Fig. 3 zeigt einen Ausschnitt einer weiteren beispielhaften Ausgestaltung der erfindungsgemäßen Anordnung in Draufsicht (vgl. Fig. 2), wobei die Aussparungen (60, 66) nunmehr L-förmig ausgestaltet sind und zumindest teilweise unter dem Halbleiterbauelement hervorragen.

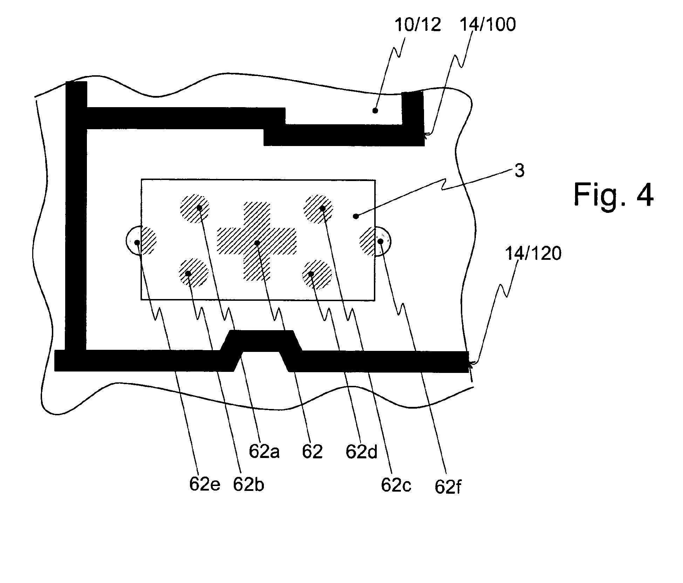

Fig. 4 zeigt einen Ausschnitt einer weiteren beispielhaften Ausgestaltung der erfindungsgemäßen Anordnung in Draufsicht (vgl. Fig. 2), wobei hier schematisch angedeutet nunmehr eine Aussparung (62) in kreuzförmiger Ausgestaltung angeordnet ist, die mittig gänzlich unter der dem Halbleiterbauelement zugeordneten Fläche liegt. Beispielhaft sind um die mittig angeordnete Aussparung zusätzlich mehrere zylinderförmige Aussparungen (62 a-f) angeordnet, wobei einige (62 a-d) gänzlich unter der dem Halbleiterbauelement zugeordneten Fläche liegen, andere (62 e,f) mit einem Segmentabschnitt sichtbar unter dem Halbleiterbauelement hervorragen.

## Patentansprüche

1. Anordnung mit einer Verbindungseinrichtung (1) zur elektrisch leitenden Verbindung mit mindestens einem Halbleiterbauelement (3 a/b, 4, 5) und mit einem Füllstoff (8),
wobei die Verbindungseinrichtung (1) als ein Folienverbund aus mindestens einer isolierenden Folie (14) und zwei elektrisch leitenden Folien (10, 12) ausgebildet ist, dieser Folienverbund in einem Schichtaufbau jeweils einer elektrisch leitenden Folie (10/12) mit einer isolierenden (14) abwechselnd angeordnet ist und
und mindestens eine elektrisch leitende Folie in sich strukturiert (18) ist und somit Leiterbahnen (100,120) ausbildet,
wobei mindestens einem Halbleiterbauelement (3/4/5) mindestens eine Aussparung (60/62/64/66) in der jeweils leitenden Folie (10, 12) zugeordnet ist und die mindestens eine Aussparung (6) zumindest teilweise in dem vom Halbleiterbauelement überdeckten Bereich der elektrisch leitenden Folie (10/12) angeordnet ist und die Aussparung eine Fläche von maximal 25 Prozent der Fläche des zugeordneten Halbleiterbauelements aufweist und wobei sich zwischen der Verbindungseinrichtung (1) und dem mindestens einen Halbleiterbauelement (3 a/b) der Füllstoff (8) befindet.

2. Anordnung nach Anspruch 1,
wobei das mindestens eine Halbleiterbauelement als Leistungshalbleiterbauelement (3 a/b) oder als Treiberbauelement (4, 5) ausgestaltet ist.

3. Anordnung nach Anspruch 1,
wobei die erste elektrisch leitende Folie Noppen (16 a/b) aufweist und wobei das mindestens eine Leistungshalbleiterbauelement (3 a/b) mittels einer stoff- oder kraftschlüssigen Verbindung mit den Noppen (16a) elektrisch leitend verbunden ist.

4. Anordnung nach Anspruch 1,
wobei das mindestens eine Treiberbauelement (4, 5) mittels einer stoffschlüssigen Klebeverbindung (9) mit der zweiten elektrisch leitenden Folie (12) verbunden ist.

5. Anordnung nach Anspruch 1,
wobei die mindestens eine Aussparung zylinderförmig und/oder L-förmig und/oder kreuzförmig ausgestaltet ist.

6. Anordnung nach Anspruch 1,
wobei die Aussparung mit einem Teilabschnitt ihrer Fläche sichtbar unter dem zugeordneten Halbleiterbauelement hervorragt.

7. Anordnung nach Anspruch 1,
wobei die Aussparung mittig und mit seiner gesamten Fläche unterhalb des zugeordneten Halbleiterbauelement angeordnet ist.

8. Anordnung nach Anspruch 1,
wobei die Aussparung eine Tiefe zwischen 20 und 100 Prozent der Dicke der elektrisch leitenden Folie (10, 12) aufweist.

9. Anordnung nach Anspruch 1,
wobei die Fläche aller einem Halbleiterbauelement zugeordneten Aussparungen weniger als 50 Prozent der Fläche dieses Halbleiterbauelements beträgt.
